# FASCICULE DE BREVET EUROPEEN

(11) **EP 2 828 078 B1**
(45) Date de publication et mention de la délivrance du brevet: **29.06.2016**
(21) Numéro de dépôt: 13719906.3
(22) Date de dépôt: 22.03.2013
(51) Int. Cl.: B32B 17/10, H01L 31/042, H01L 31/048

(54) **UTILISATION D'UNE STRUCTURE MULTICOUCHE A BASE DE POLYMERE HALOGENE COMME FEUILLE DE PROTECTION DE MODULE PHOTOVOLTAIQUE**
VERWENDUNG EINER AUF EINEM HALOGENIERTEN POLYMER BASIERENDEN MEHRSCHICHTIGEN STRUKTUR ALS SCHUTZFOLIE FÜR EIN PHOTOVOLTAIKMODUL
USE OF A MULTILAYER STRUCTURE BASED ON A HALOGENATED POLYMER AS A PROTECTIVE SHEET OF A PHOTOVOLTAIC MODULE

(30) Priorité: 23.03.2012 FR 1252615
(43) Date de publication de la demande: 28.01.2015
(73) Titulaire: Arkema France, 92700 Colombes (FR); Commissariat à l'Énergie Atomique et aux Énergies Alternatives, 75015 Paris (FR)
(72) Inventeur: BONNET, Anthony, 69720 Saint Laurent De Mure (FR); CROS, Stéphane, 73000 Chambery (FR); HIDALGO, Manuel, 69530 Brignais (FR)
(74) Mandataire: Cabinet Plasseraud
(86) Numéro de dépôt international: PCT/FR2013/050618
(87) Numéro de publication internationale: WO 2013/140101

(56) Documents cités:
- EP-A2- 1 054 456
- WO-A1-2011/103341
- US-A1- 2007 295 387
- US-A1- 2012 048 349
- US-B1- 6 335 479

## Description

### DOMAINE TECHNIQUE

La présente invention se rapporte à l'utilisation d'une structure multicouche dans la feuille de protection avant et/ou arrière d'un module photovoltaïque, ladite structure multicouche comprenant un substrat à base de polymère halogéné recouvert d'au moins un empilement de deux couches de SiO₂ et SiOₓN_{y}H_{z}, respectivement. Elle concerne également un module photovoltaïque comprenant la structure multicouche précitée dans sa feuille de protection avant et/ou arrière.

### ARRIERE-PLAN DE L'INVENTION

Le réchauffement climatique, lié aux gaz à effet de serre dégagés par les énergies fossiles, a mené au développement de solutions énergétiques alternatives qui n'émettent pas de tels gaz lors de leur fonctionnement, comme par exemple les modules photovoltaïques. Ceux-ci peuvent être efficacement utilisés pour produire de l'électricité raccordée au réseau électrique soit en ferme ou centrale solaire, soit à partir de nombreux petits producteurs particuliers, pour alimenter en électricité une habitation, ou pour fournir de l'électricité à des dispositifs qui ne peuvent pas être raccordés ponctuellement, ou de manière permanente, au réseau électrique, tels que des téléphones portables, des horodateurs, des abribus, des appareils ou des dispositifs d'éclairage dans des endroits isolés, etc.

Un module photovoltaïque, ou panneau solaire, est un générateur électrique permettant de transformer une partie de l'énergie solaire qu'il reçoit en courant continu ; il est constitué d'un ensemble de cellules photovoltaïques à base d'un matériau semi-conducteur tel que le silicium, reliées entre elles électriquement et protégées par un matériau encapsulant adhésif, généralement à base de copolymère éthylène/acétate de vinyle (EVA). Une feuille protectrice supérieure (ou « frontsheet » en anglais) et une feuille protectrice au dos du module (ou "backsheet" en anglais) sont disposées contre chaque face de l'encapsulant. Ces feuilles protectrices avant et arrière, nommées couramment en français sous les termes de face avant (FAV) et face arrière (FAR) des modules, peuvent, à leur tour être constituées d'une ou plusieurs couches de matériaux semblables ou différents. En fonction de la technologie des cellules photovoltaïques à protéger et des caractéristiques souhaitées pour le module, les faces avant et arrière devront présenter des propriétés particulières. Ainsi, par exemple, les panneaux les plus répandus actuellement contiennent des cellules à base de silicium mono ou multi-cristallin, encapsulées par de l'EVA et protégées, en face avant, par une plaque de verre et, en face arrière, par une structure multi-couche contenant du poly(téréphtalate d'éthylène) (PET) entre deux couches à base d'un polymère fluoré comme le poly(fluorure de vinyle) (PVF) ou le poly(fluorure de vinylidène) (PVDF). Dans cette configuration, la face avant en verre offre une bonne protection aux chocs, une bonne transparence et une excellente protection contre l'humidité, malgré les inconvénients d'un poids conséquent car le verre, en épaisseur typique de 3 mm, est le contributeur principal au poids du module. Le verre offre également une bonne résistance au vieillissement. Dans cette configuration, la face arrière a pour fonction de protéger également la cellule contre l'humidité, même si le niveau de protection est très inférieur à celui qu'offre le verre, mais aussi d'assurer l'isolation électrique des cellules, de bloquer les rayons UV et de présenter une bonne résistance mécanique, en particulier à la déchirure, tout en permettant au module de résister au vieillissement pendant sa durée de vie qui doit dépasser, dans beaucoup de cas, 20 ans. On comprend que la nature et la conception de ces feuilles de protection avant et arrière jouent donc un rôle primordial dans la longévité du module photovoltaïque.

Pour pallier l'inconvénient du manque de légèreté, voire de flexibilité, des modules à face avant en verre, l'homme de l'art a imaginé sa substitution par des films polymères devant offrir un maximum de propriétés satisfaisantes, notamment en termes de transparence, de résistance au vieillissement et d'imperméabilité aux gaz, notamment à l'oxygène et à la vapeur d'eau. Il est cependant connu que les films polymères offrent une protection aux gaz qui est, au mieux, médiocre.

Il a été proposé d'améliorer l'étanchéité aux gaz d'un module photovoltaïque en déposant, sur sa feuille de protection avant en polymère, une couche mince d'un matériau inorganique dense. Ainsi, le document US 2010/0258162 divulgue une couche de protection avant de module photovoltaïque flexible, comprenant un substrat transparent en polymère halogéné tel que le PVDF (polyfluorure de vinylidène) éventuellement recouvert, côté extérieur, d'une couche de SiOx destinée à renforcer ses propriétés barrière. Il est connu que la couche de SiOx peut être déposée par des procédés tels que le dépôt chimique en phase vapeur, la pulvérisation réactive ou l'évaporation thermique. Cependant, ce type de dépôt inorganique génère des contraintes mécaniques liées notamment aux différences de comportements mécanique et thermique entre la couche inorganique et le polymère, notamment à leurs différences de modules élastiques, de capacités de déformation et de coefficients d'expansion thermique. Ces contraintes occasionnent un endommagement de la couche inorganique déposée, ce qui a pour effet de limiter ses propriétés fonctionnelles. Des fissures peuvent alors apparaître, qui réduisent les propriétés barrières aux gaz de l'ensemble formé par le substrat polymère et le dépôt inorganique. Par ailleurs, ces techniques de dépôt de SiOx sont relativement coûteuses. Pour pallier cet inconvénient, il est certes possible de déposer la couche de SiOx par voie sol-gel. Toutefois, la couche ainsi obtenue est poreuse et ne peut donc pas remplir sa fonction de couche barrière aux gaz.

La solution proposée dans le document US 2003/0203210 n'est pas non plus satisfaisante. Il est décrit un procédé consistant à réaliser des empilements alternés de couches inorganiques et de couches de polymère (tel qu'un polymère acrylique), ayant une épaisseur de 1 µm à quelques µm, sur un substrat polymère épais, notamment à base de polyester tel que le PET. L'alternance de couches inorganiques et organiques permet de décorréler les défauts de chaque couche inorganique et ainsi d'améliorer considérablement les propriétés barrières aux gaz, de sorte que le substrat polymère ainsi recouvert possède des propriétés barrières aux gaz suffisantes pour protéger des dispositifs fortement sensibles à l'atmosphère tels que les dispositifs d'optoélectronique organique ou OLED (Organic Light Emitting Diodes) et a fortiori des dispositifs photovoltaïques largement moins sensibles à l'humidité. Cependant, de telles structures alternées ont un coût de réalisation élevé du fait de l'emploi de chambres de dépôts multiples et de techniques de dépôt sous vide, ce qui les rend peu adaptées à une utilisation dans des modules photovoltaïques.

D'autre part, le vieillissement naturel des supports polymères couramment utilisés, comme le PET, constitue un inconvénient majeur pour des structures transparentes qui sont amenées à être exposées pendant longtemps, typiquement de nombreuses années, à l'agression de la lumière, en particulier de sa composante ultra-violette. Même lorsqu'ils sont traités pour être rendus étanches aux gaz, les supports polymères comme le PET peuvent se dégrader du fait de l'exposition du support à des quantités minimes, mais non négligeables, d'oxygène et d'eau, en conjonction avec l'agression des rayons ultraviolets. Il en est également ainsi de la structure proposée dans la thèse d'A. MORLIER, Propriétés barrières de structures hybrides - Application à l'encapsulation des cellules solaires, Université de Grenoble (2011). Cette structure est préparée par dépôt de perhydropolysilazane (PHPS) sur un substrat en PET, puis conversion du PHPS par irradiation VUV et UV pour former au moins un empilement ayant une épaisseur totale de 250 nm et comprenant une couche de PHPS partiellement converti en nitrure de silicium hydrogéné, une couche interfaciale partiellement convertie d'oxynitrure de silicium et une couche mince de silice rigide. Différents empilements sont réalisés, éventuellement séparés les uns des autres par une couche de PVA. Si cette structure présente des avantages incontestables vis-à-vis de l'art antérieur, son étanchéité aux gaz nécessite d'être encore améliorée.

Or, il est apparu à la Demanderesse que l'utilisation d'un polymère halogéné permettait de résoudre ce problème.

Il a, certes, été suggéré dans le document WO 2011/062100 de revêtir un substrat en PVC (polychlorure de vinyle) d'une couche formant barrière en SiOx, obtenue à partir d'une solution de polysilazane et constituée d'oxyde de silicium ayant des régions de densités différentes. Aucune application à la protection des modules photovoltaïques n'a toutefois été envisagée, puisque ce document vise à proposer un film de protection d'un élément électroluminescent.

Il a également été suggéré dans les documents JP2011-143327 et JP2011-173057 d'appliquer une ou plusieurs couches formant barrière sur un substrat qui peut être en PVC, par dépôt de perhydropolysilazane sur le substrat, suivi soit de deux irradiations VUV sous des atmosphères différentes, soit d'un traitement du substrat (notamment aux UV) puis d'une irradiation VUV. Toutefois, l'irradiation VUV est toujours réalisée en présence d'un taux d'oxygène et/ou d'eau élevé qui ne permet pas d'obtenir une couche barrière satisfaisante.

Par ailleurs, il a été proposé dans le document US 2011/0315206 de recouvrir la couche de protection avant d'un module photovoltaïque, constituée de verre, d'un film transparent, résistant à l'abrasion, constituée par exemple d'un fluoropolymère hydrophobe qui est soit chargé de particules inorganiques, soit greffé inorganique. Une couche dure formant barrière à l'humidité peut être intercalée entre le substrat en verre et le film. Celle-ci peut notamment être formée d'oxyde de silicium obtenu à partir de perhydropolysilazane. Il serait souhaitable de pouvoir disposer d'une couche de protection avant ou arrière de module photovoltaïque qui soit plus flexible et plus légère que celle proposée dans ce document.

D'autres couches de protection avant ou arrière de modules photovoltaïques, renfermant un polymère halogéné, ont été décrites dans les documents WO 2011/103341, EP 1 054 456, US-6,335,479, US 2012/048349 et US 2007/295387. Aucun de ces documents ne divulgue toutefois une structure comprenant une couche de SiOxNyHz interposée entre un substrat fluoré et une couche de SiO2, cette couche de SiOxNyHz étant plus épaisse que la couche de SiO2.

### EXPOSE DE L'INVENTION

La présente invention a pour objet l'utilisation d'une structure multicouche dans la feuille de protection avant et/ou arrière d'un module photovoltaïque selon la revendication 1 comprenant des cellules photovoltaïques recouvertes d'un encapsulant. La feuille de protection avant et/ou arrière dans laquelle est incluse la structure multicouche ne contient pas de couche de verre d'une épaisseur de 50 µm ou plus. Cette structure multicouche comporte : (a) un substrat renfermant au moins un polymère halogéné, et (b) au moins un empilement d'une couche (A) de SiO₂ et d'une couche (B) en SiOₓN_{y}H_{z} disposée entre le substrat et la couche (A). Ledit empilement est disposé sur la face du substrat tournée vers l'encapsulant et éventuellement sur la face opposée du substrat. La couche (A) et la couche (B) présentent des épaisseurs (e_{A}, e_{B}) telles que l'épaisseur (e_{A}) de la couche (A) est inférieure ou égale à 60 nm, l'épaisseur (e_{B}) de la couche (B) est supérieure à deux fois l'épaisseur (e_{A}) de la couche (A) et la somme des épaisseurs de la couche (A) et de la couche (B) est comprise entre 100 nm et 500 nm, et dans laquelle z est strictement inférieur au rapport (x+y)/5, avantageusement z est strictement inférieur au rapport (x+y)/10.

La présente invention a également pour objet un module photovoltaïque renfermant des cellules photovoltaïques protégées par un encapsulant, une feuille protectrice avant et une feuille protectrice arrière, dans lequel la feuille protectrice avant et/ou arrière comprend une structure multicouche telle que définie ci-dessus et ne contient pas de couche de verre d'une épaisseur de 50 µm ou plus.

La structure multicouche utilisée selon l'invention constitue un film ayant une bonne résistance chimique et au vieillissement, qui peut être transparent et qui permet de protéger des composants photovoltaïques vis-à-vis de l'oxygène pendant le plus grand nombre d'années, et ce à un coût de production acceptable. En particulier, l'utilisation d'une technique de dépôt en phase liquide de l'empilement bicouche selon l'invention permet d'obtenir de façon simple et à bas coût un niveau d'étanchéité aux gaz qui ne peut être obtenu par des technologies classiques de dépôt, telles que le dépôt physique en phase vapeur et le dépôt chimique en phase vapeur.

### DESCRIPTION DETAILLEE DE MODES DE REALISATION

La structure multicouche utilisée selon l'invention comprend, et est de préférence constituée de, un substrat renfermant au moins un polymère halogéné et au moins un empilement constitué d'une couche de SiO₂ et d'une couche en matériau de type SiOₓN_{y}H_{z} interposée entre le substrat et la couche de SiO₂. La couche de type SiOₓN_{y}H_{z} forme une couche d'accommodation mécanique entre le substrat et la couche de SiO₂ et permet d'adapter les contraintes entre le substrat et la couche de SiO₂ ce qui limite la détérioration de la couche de SiO₂ et améliore donc l'étanchéité aux gaz de la couche de SiO₂. En d'autres termes, l'interposition d'une couche formant une interface mécanique plus épaisse et moins rigide que la couche de SiO₂ permet d'éviter la rupture de la couche de SiO₂.

Dans cette structure, le substrat comprend au moins un polymère halogéné, de préférence transparent. Il s'agit généralement d'un polymère thermoplastique. On entend par polymère halogéné au sens de l'invention, un homopolymère ou copolymère dont au moins l'un des monomères comporte une liaison C-X, où X est un atome de fluor, chlore ou brome. Le polymère halogéné peut en particulier être un homo- ou copolymère fluoré et/ou chloré, de préférence un homo- ou copolymère fluoré.

Les homo- et copolymères fluorés peuvent par exemple être choisis parmi ceux comprenant au moins 50% molaire, et avantageusement constitués, de monomères de formule (I) :

CFX=CHX' (I)

où X et X' désignent indépendamment un atome d'hydrogène ou d'halogène (en particulier de fluor ou de chlore) ou un radical alkyle perhalogéné (en particulier perfluoré), tels que :
- le poly(fluorure de vinylidène) (PVDF), de préférence sous forme α,
- les copolymères de fluorure de vinylidène avec par exemple l'hexafluoropropylène (HFP), le chlorotrifluoroéthylène (CTFE), l'hexafluoropropylène (HFP), le trifluoroéthylène (VF3) ou le tétrafluoroéthylène (TFE),
- les homo- et copolymères de trifluoroéthylène (VF3),
- les copolymères fluoroéthylène / propylène (FEP),
- les copolymères d'éthylène avec le fluoroéthylène/propylène (FEP), le tétrafluoroéthylène (TFE), le perfluorométhylvinyl éther (PMVE), le chlorotrifluoroéthylène (CTFE) ou l'hexafluoropropylène (HFP), et
- leurs mélanges,
certains de ces polymères étant notamment commercialisés par la société ARKEMA sous la dénomination commerciale Kynar^{®}.

Un exemple préféré de polymère chloré est le poly (chlorure de vinyle) ou PVC. Un tel polymère est notamment commercialisé par la société ARKEMA sous la dénomination commerciale Lacovyl^{®}. D'autres polymères chlorés utilisables dans cette invention sont le poly(chlorure de vinyle chloré) (PVCC) tel que les Lucalor^{®} d'ARKEMA et les copolymères de chlorure de vinyle avec des monomères tels que l'acrylonitrile, l'éthylène, le propylène ou l'acétate de vinyle, ainsi que le poly(chlorure de vinylidène) et ses copolymères avec des monomères vinyliques, notamment acryliques. Il est également possible que le polymère chloré utilisé selon l'invention soit un mélange incluant au moins deux des polymères ou copolymères chlorés ci-dessus. Dans le cas des copolymères de chlorure de vinyle, il est préférable que la proportion de motifs chlorure de vinyle soit supérieure à 25% et de préférence inférieure à 99% du poids total du copolymère.

Les polymères halogénés utilisés selon l'invention peuvent être obtenus suivant des procédés de polymérisation en suspension, en micro-suspension, en émulsion ou en masse, bien connus de l'homme du métier.

De manière avantageuse, on préfère utiliser le poly(fluorure de vinylidène) ou PVDF.

Le substrat en polymère halogéné peut par exemple avoir une épaisseur allant de 5 à à 500 µm, notamment de 20 à 100 µm et de manière préférée de 25 à 60 µm. Le substrat polymère halogéné peut être traité en surface, par exemple, par traitement de type Corona, de manière à améliorer son adhérence aux couches de dépôt inorganique. On préfère d'une manière générale soumettre le substrat à tout traitement permettant d'augmenter sa tension superficielle à des valeurs de l'ordre de 50 - 60 mN/m (ou dyn/cm)]. La résistance du substrat au rayonnement, notamment UV, peut-être renforcée par ajout de stabilisants UV organiques ou inorganiques.

Comme indiqué précédemment, ce substrat polymère est recouvert, sur au moins l'une de ses faces, d'au moins un empilement bicouche. Cet empilement bicouche peut être présent sur la face du substrat tournée vers l'encapsulant et éventuellement sur sa face opposée. Chaque couche de cet empilement a une composition et une épaisseur particulières. Plus précisément, cet empilement est constitué d'une couche de SiO₂ et d'une couche en matériau de type SiOₓN_{y}H_{z} interposée entre le substrat et la couche de SiO₂. La composition de la couche SiOₓN_{y}H_{z} est telle que y et z sont strictement supérieurs à 0 et z est strictement inférieur au rapport (x+y)/5, avantageusement z est strictement inférieur au rapport (x+y)/10. On préfère en outre que la valeur de x décroisse de l'interface entre la couche en SiOₓN_{y}H_{z} et la couche de SiO₂ vers le substrat, et que la valeur de y croisse de l'interface entre la couche en SiOₓN_{y}H_{z} et la couche de SiO₂ vers le substrat. x varie de 2 à 0 et/ou y varie d'une valeur strictement supérieure à 0 mais inférieure à 1 jusqu'à une valeur de 1. Par ailleurs, ces couches présentent des épaisseurs telles que l'épaisseur de la couche de SiO₂ est inférieure ou égale à 60 nm, l'épaisseur de la couche en SiOₓN_{y}H_{z} est supérieure à deux fois l'épaisseur de la couche de SiO₂ et la somme des épaisseurs de ces couches est comprise entre 100 nm et 500 nm. Ainsi, la couche de SiO₂ peut avoir par exemple une épaisseur de 40 à 60 nm et la couche en SiOₓN_{y}H_{z} peut avoir une épaisseur allant par exemple de 100 à 200 nm, notamment de 150 à 200 nm.

Selon une forme d'exécution avantageuse de l'invention, les modules d'Young M_{A} de la couche de SiO₂ et M_{B} de la couche en SiOₓN_{y}H_{z} sont tels que :
- M_{A} > 30 GPa, et
- M_{B} < 20 GPa.

Ces conditions avantageuses sur les modules d'Young des couches A et B permettent d'améliorer encore les propriétés barrières aux gaz. La mesure des modules d'Young des couches A et B peut être réalisée suivant les techniques décrites dans le document *"*A simple guide to determine elastic properties of films on substrate from naoindentation experiments", de S. Bec, A. Tonck and J Loubet, dans Philosophical Magazine, Vol.86, Nos. 33-35, 21 Nov. -11 Dec. 2006, pp. 5347-5358 et dans le document *"*In vivo measurements of the elastic mechanical properties of human skin by indentation tests", dans Medical Engineering & Physics, 30(2008) pp. 599-606. En outre, dans cette forme d'exécution, la couche en SiOₓN_{y}H_{z} est non seulement plus épaisse que la couche de SiO₂, mais aussi moins rigide que celle-ci, du fait de son module d'Young plus faible, de sorte qu'elle permet de mieux adapter les contraintes, et de limiter la déformation différentielle, entre la couche de SiO₂ et le substrat.

Selon une forme d'exécution avantageuse de l'invention, l'indice de réfraction de la structure multicouche est de préférence supérieur à 1,5. Les matériaux de ses couches constitutives peuvent être amorphes.

L'empilement bicouche précité peut être formé suivant un procédé qui sera maintenant décrit.

Ce procédé comprend une étape de conversion d'un perhydropolysilazane (PHPS), c'est-à-dire d'un composé de formule (I) : 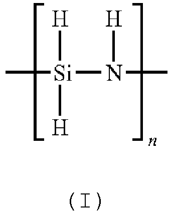 où n est un nombre entier tel que la masse moléculaire moyenne en nombre du PHPS est comprise entre 150 et 150.000 g/mol.

Dans ce procédé, le PHPS est utilisé sous forme de solution dans un solvant aprotique, polaire ou apolaire, tel que des éthers (dont le dibutyl éther), des esters, des cétones, des hydrocarbures aliphatiques ou aromatiques (dont le xylène) ou des mélanges de ces solvants. La concentration du PHPS dans la solution dépend de l'épaisseur du film liquide à déposer. Pour une épaisseur de film de l'ordre de 5 µm, elle peut ainsi aller de 2 à 15% en poids de PHPS. L'application de la solution de PHPS sur le substrat peut se faire par tout moyen connu, notamment par héliographie, flexographie, enduction par filière à fente, centrifugation, dépôt au rouleau, pulvérisation ou enduction à l'aide de barres de Meyer. On préfère par ailleurs que le dépôt de PHPS soit effectué à température ambiante.

Dans tous les cas, la solution de PHPS peut être modifiée, afin que la mouillabilité de la solution lors du dépôt soit adaptée à la faible énergie libre de surface de certains substrats halogénés tels que le PVDF, en particulier lorsque celui-ci n'est pas traité en surface. Ainsi, dans le cas où le PHPS est utilisé sous forme de solution dans un solvant polaire aprotique tel que le dibutyl éther, il pourra être utile de le diluer à l'aide d'un solvant apolaire tel qu'un alcane. Le rapport volumique du solvant apolaire au solvant polaire aprotique peut être ajusté par l'homme du métier en fonction de la nature chimique du substrat et peut notamment aller de 1:10 à 1:2. En variante, il est possible d'augmenter l'énergie de surface du substrat halogéné en lui faisant subir un traitement par plasma ou corona.

Après application de la solution de PHPS, le solvant est évaporé soit par séchage libre à l'air, sous flux de gaz inerte comme l'azote ou sous vide, à température ambiante, soit par lampe infrarouge ou air ou air appauvri ou azote chauds. La couche de PHPS déposée a avantageusement une épaisseur, après évaporation du solvant, comprise entre 100 et 400 nm, de préférence entre 150 et 350 nm, mieux, entre 200 et 300 nm.

La conversion du PHPS appliqué sur le substrat peut ensuite être effectuée au moyen d'une irradiation à l'aide d'un rayonnement UV à une longueur d'onde supérieure ou égale à 200 nm, notamment comprise entre 240 et 280 nm et, simultanément ou successivement, d'une irradiation à l'aide d'un rayonnement ultraviolet du vide ou VUV (pour "Vacuum Ultraviolet") à une longueur d'onde inférieure ou égale à 200 nm, notamment comprise entre 180 et 200 nm, sous une atmosphère présentant un taux d'oxygène inférieur à 500 ppm et un taux d'eau inférieur ou égal à 1000 ppm.

L'irradiation est généralement effectuée à température ambiante et elle peut par exemple se faire au moyen d'une lampe mercure basse pression qui combine une longueur d'onde VUV de 185 nm et une longueur d'onde UV de 254 nm. La dose reçue pour le rayonnement à 185 nm est par exemple inférieure à 20 joules/cm².

De manière très avantageuse, la formation de la couche de SiO₂ et la formation de la couche de SiOₓN_{y}H_{z} sont simultanées. Le procédé de formation de ces couches est conduit dans des conditions spécifiques appauvries en oxygène et en eau qui permettent de limiter l'épaisseur de la couche de SiO₂ ainsi que la conversion de la couche en SiOₓN_{y}H_{z}, et ainsi d'obtenir les caractéristiques de composition et d'épaisseur des couches mentionnées ci-dessus.

Dans cette forme d'exécution, la durée de l'irradiation est fonction de l'épaisseur du dépôt et va généralement de 1 à 10 minutes. Pour une épaisseur de 200 à 300 nm, un temps d'irradiation d'environ 5 minutes est généralement suffisant.

De manière alternative, le procédé peut se dérouler en deux étapes: lors d'une première étape, une couche de PHPS est déposée sur le substrat. Cette couche est ensuite soumise à une irradiation UV de longueur d'onde supérieure à 220 nm en présence d'un taux d'oxygène et d'eau négligeable, i.e. inférieur à 10 ppm. Lors d'une deuxième étape, une autre couche de PHPS est déposée sur la première couche, puis cette deuxième couche subit une irradiation par VUV à une longueur d'onde inférieure à 200 nm en présence d'oxygène, la concentration d'oxygène étant alors comprise entre 10 ppm et 500 ppm.

On notera que la quantité de liaisons Si-H restantes après conversion du PHPS dans les couches de SiO₂ et de SiOₓN_{y}H_{z} est très faible. Elle peut être mesurée par spectrométrie infrarouge à transmission de Fourier (FTIR), les spectres étant enregistrés en réflexion totale atténuée (ATR). Cette analyse permet de suivre la cinétique de conversion du PHPS, en se fondant sur le Tableau 1 suivant :

**Tableau 1**

| Nombre d'onde (cm⁻¹) | Liaison caractérisée |
|---|---|
| 450-460, 800, 1070 | Si-O-Si |
| 800-900 | Si-N-Si |
| 880, 2100-2200 | H-Si-H |
| 940, 2800-3700 (bande large) | Si-OH |
| 1180 | Si-NH |
| 3350 | N-H |

Selon une autre possibilité, la faible quantité de Si-H peut être détectée en réflexion sur les substrats décrits dans l'invention. La transmittance dans la gamme de nombres d'onde 2100-2300 cm⁻¹ est alors supérieure à 80%, de préférence supérieure à 90%.

La composition chimique des couches après irradiation peut en outre être vérifiée par spectrométrie de masse à temps de vol en ionisation secondaire (TOF-SIMS), par exemple à l'aide d'un spectromètre IontoF V équipé d'une source d'ions Bi⁺ de 25 keV et 1,5 pA et d'une source d'ions Cs⁺ de 2 keV et 128 nA.

En plus du substrat et de l'empilement bicouche décrits précédemment, la structure utilisée selon l'invention peut comprendre une couche d'un matériau polymère déposée sur l'empilement bicouche, par exemple par évaporation et/ou polymérisation. Le polymère utilisé dans cette couche peut être halogéné ou non. Il peut notamment être choisi parmi des matériaux hybrides tels que les organosilanes, des matériaux polymères à blocs à structure lamellaire, co-continue ou de type matrice/inclusions, tels que des copolymères à blocs acryliques comme le poly(méthacrylate de méthyle)-*b-*poly(acrylate de butyle) ou le poly(méthacrylate de méthyle)-*b*-poly(acrylate de butyle)-*b*-poly(méthacrylate de méthyle), ou encore des matériaux composites ou nano-composites comprenant une matrice polymère et des renforts tels que des nanotubes de carbone, des argiles, des zéolithes, du charbon actif et/ou des terres de diatomée. La couche de matériau polymère a de préférence une épaisseur inférieure ou égale à celle du substrat, même si des couches de matériau polymère d'épaisseur supérieure à celle du substrat peuvent être préférées dans des structures particulières Les couches de ce matériau polymère peuvent avoir, indépendamment les unes des autres, une épaisseur de 1 à 30 µm, par exemple. Il est ainsi possible de conférer à la structure multicouche utilisée selon l'invention des propriétés de barrière à d'autres éléments que les gaz, par exemple aux rayons UV, ou des propriétés d'absorption d'humidité, par exemple. Grâce à la couche en SiOₓN_{y}H_{z}, les problèmes d'ordre mécanique lors du dépôt de la couche en matériau polymère précitée sont limités, tels que la courbure de l'ensemble de la structure.

En variante ou en plus, la structure multicouche peut comporter n empilements, n étant un entier positif supérieur à 1, chaque empilement comportant une couche (A) de SiO₂ et une couche (B) en matériau de type SiOₓᵢN_{yi}H_{zi}, i étant un entier positif compris entre 1 et n et zᵢ étant strictement inférieur au rapport (xᵢ+yᵢ)/5, avantageusement zᵢ est strictement inférieur au rapport (xᵢ+yᵢ)/10, xᵢ, yᵢ, zᵢ étant identiques ou non pour les différents valeurs de i. Une telle structure peut être préparée en répétant les étapes du procédé décrit ci-dessus. L'effet sur les propriétés de barrière aux gaz est encore augmenté.

Une structure multicouche particulièrement préférée est celle comprenant un ou plusieurs des empilements décrits ci-dessus, disposés symétriquement d'un côté et de l'autre (recto et verso) du substrat. Un seul empilement bicouche ou n empilements de bicouches peuvent ainsi, avantageusement, être disposés côté recto et côté verso du substrat polymère.

Les structures multicouches comportant n empilements de bicouches inorganiques (d'un côté et/ou de l'autre du substrat) peuvent comporter au moins une couche en matériau polymère disposée entre la couche de SiO₂ d'un empilement et la couche en SiOₓᵢN_{yi}H_{zi} de l'empilement suivant directement, par exemple n-1 couches en matériau polymère, chacune des couches en matériau polymère étant disposée entre deux empilements. Les propriétés fonctionnelles de la structure sont ainsi démultipliées du fait de la mise en série de n couches denses Aᵢ en SiO₂ et des n-1 couches d'interposition en matériau polymère.

Toutes les structures multicouches décrites précédemment sont particulièrement utiles comme face avant de modules photovoltaïques. On préfère dans ce cas qu'elles soient transparentes, c'est-à-dire qu'elles présentent une transmittance totale, mesurée suivant la norme ASTM D1003, supérieure à 85%. De plus, ces structures peuvent être insérées dans des laminats multi-couches opaques ou transparents pouvant servir comme face arrière de modules photovoltaïques.

Pour ces applications, la structure multicouche est préalablement mise en forme suivant des techniques classiques de réalisation de films, feuilles ou plaques. A titre d'exemples, on peut citer les techniques d'extrusion soufflage de gaine, d'extrusion lamination, d'extrusion couchage, d'extrusion de film à plat ou encore d'extrusion de feuilles. Toutes ces techniques sont connues de l'homme du métier et il saura adapter les conditions de mise en oeuvre des différentes techniques (température des extrudeuses, raccord, filières, vitesse de rotation des vis, températures de refroidissement des cylindres de refroidissement, etc..) pour former la structure selon l'invention ayant la forme et les épaisseurs désirées. On ne sortirait pas de l'invention si cette structure était mise en forme par des techniques de pressage, de lamination avec des adhésifs en voie solvant ou aqueuse, ou si elle subissait une étape de recuit supplémentaire.

L'invention a donc également pour objet un module photovoltaïque renfermant des cellules photovoltaïques protégées par un encapsulant, une feuille protectrice avant et une feuille protectrice arrière, dans lequel la feuille protectrice avant et/ou arrière comprend une structure multicouche telle que décrite précédemment et ne contient pas de couche de verre d'une épaisseur de 50 µm ou plus.

Comme indiqué précédemment, la structure multicouche peut constituer la feuille de protection avant du module photovoltaïque. Dans ce cas, la feuille de protection arrière peut être constituée d'une structure à trois couches, renfermant une couche centrale à base de polyester tel que le polyéthylène téréphtalate (PET), entourée de deux couches à base de polymère fluoré, tel que le polyfluorure de vinylidène (PVDF), le polyfluorure de vinyle (PVF) ou le poly(éthylène/tétrafluoroéthylène) (ETFE). En variante, la feuille de protection arrière peut être constituée de polyoléfines, en particulier de polypropylène, éventuellement greffées polyamide ou fonctionnalisées par l'anhydride maléique, seules ou associées à une ou plusieurs couches de polymère fluoré éventuellement fonctionnalisé, tel que le PVDF. En variante encore, la feuille de protection arrière peut être constituée d'une ou plusieurs couches de polyamide éventuellement renforcées par des fibres de verre, utilisées seules ou dans une structure multicouche comportant une couche centrale de PET. En variante ou en plus, la feuille de protection arrière peut comprendre une feuille d'aluminium et/ou du verre.

Dans une autre forme d'exécution de l'invention, la structure multicouche décrite précédemment est intégrée dans la feuille de protection arrière d'un module photovoltaïque. Dans ce cas, elle peut être associée à l'un au moins des matériaux constitutifs des feuilles de protection arrière décrits ci-dessus améliorant ainsi, notablement les propriétés barrière de la feuille de protection arrière lorsque celle-ci ne comprend pas de couche en métal (comme l'aluminium) ou en verre. Elle peut en outre renfermer divers additifs dont des modifiants chocs, des pigments minéraux ou organiques, des colorants, des azurants optiques, des agents de couplage, des agents de réticulation, des plastifiants, des stabilisants thermiques, des stabilisants vis-à-vis de l'hydrolyse, des anti-oxydants (par exemple de type phénol et/ou phosphite et/ou amine), des renforts tels que de la fibre de verre, des agents ignifugeants, et leurs mélanges. La feuille de protection avant peut alors être constituée de verre, de poly(méthacrylate de méthyle) ou PMMA, d'un homo- ou copolymère fluoré tel que le PVDF, d'un mélange de polymère fluoré et de PMMA ou de structures multicouches obtenues à partir de ces matériaux.

Dans tous les cas, l'encapsulant est généralement à base d'au moins un polymère tel qu'un copolymère éthylène / acétate de vinyle (EVA), le polyvinylbutyral (PVB), des ionomères, le poly(méthacrylate de méthyle) (PMMA), un polyuréthane, un polyester, un élastomère de silicone et leurs mélanges.

En outre, les cellules photovoltaïques peuvent comprendre du silicium dopé, mono-cristallin ou polycristallin, du silicium amorphe, du tellurure de cadmium, du disiléniure de cuivre-indium, ou des matériaux organiques, par exemple.

La fabrication du module photovoltaïque peut se faire suivant les procédés connus de l'homme du métier et notamment comme décrit dans US-5,593,532. En général, l'assemblage des différentes couches peut se faire par pressage à chaud ou sous vide, ou laminage à chaud.

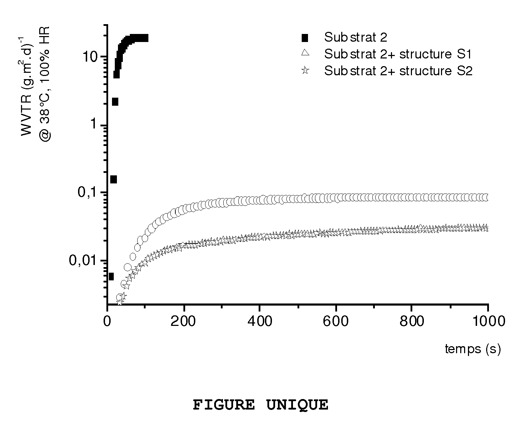

L'invention sera mieux comprise à la lumière des exemples non limitatifs suivants, pris en combinaison avec la figure annexée qui illustre le taux de transmission de la vapeur d'eau de deux structures différentes selon l'invention, par comparaison avec un substrat nu.

### EXEMPLES

### Exemple 1: Fabrication d'une structure multicouche selon l'invention

Une solution de précurseur a été préparée en mélangeant une solution commerciale de PHPS (NN 120-20 (A) fournie par CLARIANT) à 20% dans le dibutyl éther avec de l'hexane comme co-solvant, dans un rapport volumique de l'hexane au dibutyl éther de 1:5. Afin de limiter la contamination possible de la surface du substrat par des particules susceptibles de créer des défauts dans la structure multicouche après conversion, le substrat a été décontaminé à l'aide d'une machine de nettoyage de feuilles TEKNEK avant le dépôt de la couche liquide de précurseur. La solution de PHPS a ensuite été appliquée sur un substrat, constitué de PVDF (Kynar^{®} 740 d'ARKEMA) d'une épaisseur de 30 ou de 50 µm, selon le cas, et de format A4, à l'aide d'une barre de Meyer, de façon à obtenir une couche de PHPS humide de 4 à 6 µm d'épaisseur. Le solvant a alors été évaporé par séchage libre de quelques minutes à température ambiante. La couche de PHPS obtenue avait une épaisseur de 250 nm. Le substrat enduit a ensuite été placé dans une enceinte sous flux d'azote sec continu, de façon à obtenir une hygrométrie inférieure à 1000 ppm et un taux d'oxygène compris entre 10 et 500 ppm. La conversion du PHPS par irradiation a alors été effectuée à l'aide d'une lampe mercure basse pression, avec un rayonnement VUV (185 nm) et UV (254 nm), pendant une durée de 5 minutes correspondant à une dose de l'ordre de 10 J/cm².

On a ainsi obtenu une structure multicouche S1 sous forme de film.

### Exemple 2 : Evaluation des propriétés barrières des structures selon l'invention

On a mesuré le taux de transmission d'hélium ou de la vapeur d'eau en g.m⁻².jour⁻¹, désignée également par WVTR (pour "Water Vapor Transmission Rate"), en fonction du temps en jours, pour différentes structures, à savoir :
I : un substrat en polymère PVDF seul (Kynar^{®} 740 d'ARKEMA) ayant une épaisseur de 30 µm pour les mesures en hélium et de 50 µm pour les mesures en vapeur d'eau.
II : la structure S1 obtenue à l'Exemple 1
III : une structure S2 obtenue de manière similaire à l'Exemple 1, par dépôt de deux couches successives de PHPS, et renfermant donc deux empilements identiques à celui de la structure S1
IV : une structure comparative S1' correspondant à la structure S1, excepté que le substrat était constitué de PET
V : une structure S3 obtenue de manière similaire à l'Exemple 1, excepté que la couche de PHPS était déposée de chaque côté (recto et verso) du substrat en PVDF
VI : une structure comparative S3' correspondant à la structure S3, excepté que le substrat était constitué de PET.

Pour ce faire, un échantillon circulaire de chacune de ces structures a été découpé puis placé dans un appareillage tel que celui décrit dans le document US 2007/0186622.

Le protocole de test consiste à placer l'échantillon (substrat seul ou enduit) à l'interface d'une enceinte comprenant une atmosphère contrôlée et d'une enceinte de mesure sous vide poussé permanent (mesure du flux par spectrométrie de masse). Les températures du substrat et de l'atmosphère sont maintenus constantes (38°C) alors que l'hygrométrie (dans le cas de la vapeur d'eau) est saturée (équilibre liquide/ vapeur). La valeur chiffrée du WVTR est obtenue grâce au passage préalable d'un polymère référence de WVTR connu (en l'espèce, le PET).

La structure S2 offre des propriétés barrières aux gaz remarquables, comme le montre la figure annexée. Elle présente un WVTR (T = 38°C, HR = 100%) de 8.10⁻² g.m⁻².jour et un facteur d'amélioration des propriétés barrières à l'eau, par rapport au substrat seul, de 225, c'est-à-dire équivalent à celui obtenu avec les meilleures méthodes de dépôt plasma de couches inorganiques.

Le Tableau 2 ci-dessous rassemble par ailleurs les propriétés barrières des structures testées, obtenues dans un test de perméation à l'hélium.

La mesure des propriétés barrière à l'hélium est effectuée avec le même appareillage que précédemment décrit ; dans ce cas, l'atmosphère saturée en eau est remplacée par une atmosphère d'hélium sec de pression connue. Il a en effet été observé que la mesure de la perméabilité à l'hélium constituait un outil fiable pour évaluer les propriétés barrières à l'eau. Dans ce tableau, les propriétés barrières sont exprimées en termes de facteur d'amélioration, encore désigné par BIF (pour "Barrier Improvement Factor"), par rapport au substrat PVDF seul.

**Tableau 2**

| Propriétés barrières | |
|---|---|
| Echantillon | BIF He |
| Substrat PVDF | 1 |
| Structure S1 | 7 |
| Structure S2 | 12 |
| Structure S1' | 4 |
| Structure S3 | 25 |
| Structure S3' | 8 |

Comme il ressort du Tableau 2, l'ajout d'un (et plus particulièrement de deux) empilements bicouches permet d'améliorer significativement les propriétés barrières du substrat à base de polymère halogéné. La structure symétrique comportant un empilement bicouche de chaque côté du substrat (recto et verso) est particulièrement performante. En outre, les structures multicouches selon l'invention présentent des propriétés barrières à l'hélium nettement supérieures à des structures similaires à base de PET.

### Exemple 3 : Fabrication de modules photovoltaïques et évaluation de leur résistance au vieillissement

Un mini-module photovoltaïque a été fabriqué en utilisant le film de l'Exemple 1, selon la procédure de fabrication suivante.

Deux cellules photovoltaïques Suntech^{®} de 125 mm de côté ont été connectées (enchaînement vertical de type 1 x 2, 1 colonne, 2 lignes) par soudure des bandes conductrices de cuivre le long des deux barres omnibus présentes dans les cellules d'origine. Un tel enchaînement de cellules est appelé une chaîne de cellules 1 x 2.

La chaîne de cellules 1 x 2 a été placée entre deux feuilles coupées aux dimensions A4 d'encapsulant réticulable à base d'EVA (VistaSolar^{®} Fast Cure 486.00 fourni par la société Solutia), ayant une épaisseur proche de 400 µm avant lamination. L'assemblage résultant a été complété par une face arrière (FAR) en verre de 3,2 mm d'épaisseur, coupée aux dimensions A4, ainsi que par le film de structure S1 obtenu à l'Exemple 1, qui faisait office de face avant (FAV) du module. La face non couchée du film de structure S1 était placée à l'extérieur. Cet assemblage FAV S1/film EVA réticulable/ chaîne de cellules 1x2/ film EVA réticulable/ verre a été introduit, avec la FAR en bas, dans un laminateur pilote S1815E de la société 3S, pour procéder à la fabrication du module, selon le cycle de lamination qui suit.

L'assemblage a été introduit dans le laminateur qui se trouvait à une température de consigne de 145°C. Le laminateur possédait deux chambres séparées par une membrane souple. Le module se trouvait dans la chambre basse en contact indirect avec la platine chauffante du laminateur, du fait que des plots sortant de la platine chauffante supportaient le module, initialement à une distance de l'ordre de 1 cm de la platine. Dans une première phase de la lamination, le vide (jusqu'à moins de 10 mbar) a été fait dans les deux chambres. Cette phase, dite de dégazage, durait 5 minutes, pendant lesquelles le module a commencé à monter en température. Au bout de 5 minutes, la phase de lamination proprement dite a commencé et deux évènements se sont produits : 1) les plots se sont abaissés et le module est entré en contact direct avec la platine chaude, et 2) la pression dans la chambre haute a été portée à la pression atmosphérique, tout en maintenant la chambre basse sous vide, de sorte que la membrane souple séparant les deux chambres est venue se plaquer contre le module du fait de la différence de pression (c. 1 bar) entre les deux chambres. Cette deuxième phase durait 10 minutes, après lesquelles les deux chambres ont été remises à pression atmosphérique et le module a été extrait du laminateur. On a ainsi obtenu un module photovoltaïque prêt à être caractérisé.

Ce module photovoltaïque a été placé en chambre de vieillissement à la chaleur humide (85°C, 85% d'humidité) pendant 1.000 heures et inspecté après ce temps, à la recherche de signes de vieillissement ou de dégradation. Le module photovoltaïque présentait un très bon comportement, sans apparition de couleur (jaunissement), et l'adhésion entre les couches était conservée.

## Revendications

1. Utilisation d'une structure multicouche dans la feuille de protection avant et/ou arrière d'un module photovoltaïque comprenant des cellules photovoltaïques recouvertes d'un encapsulant,
**caractérisée en ce que** ladite structure multicouche comporte :
(a) un substrat renfermant au moins un polymère halogéné, et
(b) au moins un empilement d'une couche (A) de SiO₂ et d'une couche (B) en SiOₓN_{y}H_{z} disposée entre le substrat et la couche (A), dans laquelle la couche (A) et la couche (B) présentent des épaisseurs (e_{A}, e_{B}) telles que l'épaisseur (e_{A}) de la couche (A) est inférieure ou égale à 60 nm, l'épaisseur (e_{B}) de la couche (B) est supérieure à deux fois l'épaisseur (e_{A}) de la couche (A) et la somme des épaisseurs de la couche (A) et de la couche (B) est comprise entre 100 nm et 500 nm, et dans laquelle y et z sont strictement supérieurs à 0 et z est strictement inférieur au rapport (x+y)/5, avantageusement z est strictement inférieur au rapport (x+y)/10, et x varie de 2 à 0 et/ou y varie d'une valeur strictement supérieure à 0 et inférieure à 1 jusqu'à une valeur de 1,
ledit empilement étant disposé sur la face du substrat tournée vers l'encapsulant et éventuellement sur la face opposée du substrat,
et **en ce que** la feuille de protection avant et/ou arrière dans laquelle est incluse la structure multicouche ne contient pas de couche de verre d'une épaisseur de 50 µm ou plus.

2. Utilisation selon la revendication 1, **caractérisée en ce que** la valeur de x décroît de l'interface entre la couche (B) et la couche (A) vers le substrat, et la valeur de y croît de l'interface entre la couche (B) et la couche (A) vers le substrat.

3. Utilisation selon l'une quelconque des revendications 1 à 2, **caractérisée en ce que** le matériau de la couche (A) présente un module d'Young (M_{A}) supérieur ou égal à 30 GPa et le matériau de la couche (B) a un module d'Young (M_{B}) inférieur ou égal à 20 GPa.

4. Utilisation selon l'une quelconque des revendications 1 à 3, **caractérisée en ce que** ledit au moins un empilement est obtenu par conversion d'un perhydropolysilazane, de préférence au moyen d'une irradiation à l'aide d'un rayonnement UV à une longueur d'onde supérieure ou égale à 200 nm et, simultanément ou successivement, d'une irradiation à l'aide d'un rayonnement VUV à une longueur d'onde inférieure ou égale à 200 nm, sous une atmosphère présentant un taux d'oxygène inférieur à 500 ppm et un taux d'eau inférieur ou égal à 1.000 ppm.

5. Utilisation selon l'une quelconque des revendications 1 à 4, **caractérisée en ce que** la structure multicouche comporte une couche en matériau polymère sur la couche (A) dudit empilement, sur la face opposée à celle en contact avec la couche (B).

6. Utilisation selon l'une quelconque des revendications 1 à 5, **caractérisée en ce que** la structure multicouche comporte n empilements, n étant un entier positif supérieur à 1, chaque empilement comportant une couche (A) de SiO₂ et une couche (B) en SiOₓᵢN_{yi}H_{zi}, i étant un entier positif compris entre 1 et n et zᵢ étant strictement inférieur au rapport (xᵢ+yᵢ)/5, avantageusement zᵢ est strictement inférieur au rapport (xᵢ+yᵢ)/10, xᵢ, yᵢ, zᵢ étant identiques ou non pour les différents valeurs de i.

7. Utilisation selon la revendication 6, **caractérisée en ce que** la structure multicouche comporte au moins une couche en matériau polymère disposée entre la couche (A) d'un empilement et la couche (B) de l'empilement suivant directement.

8. Utilisation selon la revendication 7, **caractérisée en ce qu'**elle comporte n-1 couches en matériau polymère, chacune des couches en matériau polymère étant disposée entre deux empilements.

9. Utilisation selon l'une quelconque des revendications 1 à 8, **caractérisée en ce que** la structure multicouche comprend un ou plusieurs empilements disposés symétriquement d'un côté et de l'autre du substrat.

10. Utilisation selon l'une quelconque des revendications 1 à 9, **caractérisée en ce que** le polymère halogéné est choisi parmi les homo- et copolymères chlorés et/ou fluorés, de préférence les homo- et copolymères fluorés.

11. Utilisation selon la revendication 10, **caractérisée en ce que** le polymère fluoré est choisi parmi les homo- et copolymères fluorés comprenant au moins 50% molaire, et avantageusement constitués, de monomères de formule (I) :
CFX=CHX' (I)
où X et X' désignent indépendamment un atome d'hydrogène ou d'halogène (en particulier de fluor ou de chlore) ou un radical alkyle perhalogéné (en particulier perfluoré), tels que :
- le poly(fluorure de vinylidène) (PVDF), de préférence sous forme α,
- les copolymères de fluorure de vinylidène avec par exemple l'hexafluoropropylène (HFP), le chlorotrifluoroéthylène (CTFE), l'hexafluoropropylène (HFP), le trifluoroéthylène (VF3) ou le tétrafluoroéthylène (TFE),
- les homo- et copolymères de trifluoroéthylène (VF3),
- les copolymères fluoroéthylène / propylène (FEP),
- les copolymères d'éthylène avec le fluoroéthylène/propylène (FEP), le tétrafluoroéthylène (TFE), le perfluorométhylvinyl éther (PMVE), le chlorotrifluoroéthylène (CTFE) ou l'hexafluoropropylène (HFP), et
- leurs mélanges.

12. Utilisation selon la revendication 11, **caractérisée en ce que** l'homo- ou copolymère fluoré est le poly(fluorure de vinylidène).

13. Utilisation selon l'une quelconque des revendications 1 à 12, **caractérisée en ce que** la structure multicouche constitue la feuille de protection avant du module photovoltaïque.

14. Module photovoltaïque renfermant des cellules photovoltaïques protégées par un encapsulant, une feuille protectrice avant et une feuille protectrice arrière, dans lequel la feuille protectrice avant et/ou arrière comprend une structure multicouche telle que définie dans l'une quelconque des revendications 1 à 13 et ne contient pas de couche de verre d'une épaisseur de 50 µm ou plus.

## Patentansprüche

1. Anwendung einer mehrschichtigen Struktur in der vorderen und/oder hinteren Schutzfolie eines Photovoltaikmoduls, welche von einer Umhüllung bedeckte Photovoltaik-Zellen umfasst,
**dadurch gekennzeichnet, dass** die mehrschichtige Struktur umfasst:
(a) ein Substrat, das wenigstens ein halogeniertes Polymer einschließt, und
(b) wenigstens einen Stapel aus einer SiO₂-Schicht (A) und einer SiOₓN_{y}H_{z}-Schicht (B), die zwischen dem Substrat und der Schicht (A) angeordnet ist, wobei die Schicht (A) und die Schicht (B) solche Dicken (e_{A}, e_{B}) aufweisen, dass die Dicke (e_{A}) der Schicht (A) kleiner oder gleich 60 nm ist, die Dicke (e_{B}) der Schicht (B) größer als das Doppelte der Dicke (e_{A}) der Schicht (A) ist und die Summe aus der Dicke der Schicht (A) und der Dicke der Schicht (B) zwischen 100 nm und 500 nm liegt, wobei y und z in jedem Fall größer als 0 sind und z in jedem Fall kleiner ist als das Verhältnis (x+y)/5, dass z vorteilhafterweise in jedem Fall kleiner ist als das Verhältnis (x+y)/10 und wobei x zwischen 2 und 0 schwankt und/oder wobei y zwischen einem Wert, der in jedem Fall größer als 0 und kleiner als 1 ist bis zu einem Wert von 1 schwankt,
wobei der Stapel auf derjenigen Seite des Substrats angeordnet ist, die der Umhüllung zugewandt ist und eventuell auf der gegenüberliegenden Seite des Substrats,
und dadurch, dass die vordere und/oder hintere Schutzfolie in der die mehrschichtige Struktur eingeschlossen ist, keine Glasschicht mit einer Dicke von 50 µm oder mehr umfasst.

2. Anwendung nach Anspruch 1, **dadurch gekennzeichnet, dass** der Wert x von der Schnittstelle der Schicht (B) und der Schicht (A) zu dem Substrat hin abnimmt und der Wert y von der Schnittstelle zwischen der Schicht (B) und der Schicht (A) zum Substrat hin zunimmt.

3. Anwendung nach einem der Ansprüche 1 bis 2, **dadurch gekennzeichnet, dass** das Material der Schicht (A) ein Young-Modul (M_{A}) aufweist, das größer oder gleich 30 GPa ist und das Material der Schicht (B) ein Young-Modul (M_{B}) aufweist, das kleiner oder gleich 20 GPa ist.

4. Anwendung nach einem der Ansprüche 1 bis 3, **dadurch gekennzeichnet, dass** der wenigstens eine Stapel durch Umwandlung eines Perhydropolysilazans erreicht wird, bevorzugt mittels einer Bestrahlung durch UV-Strahlung mit einer Wellenlänge größer oder gleich 200 nm, und gleichzeitig oder darauffolgend mittels einer VUV-Strahlung mit einer Wellenlänge kleiner oder gleich 200 nm, in einer Atmosphäre, die einen Sauerstoffgehalt kleiner 500 ppm und einen Wassergehalt kleiner oder gleich 1.000 ppm aufweist.

5. Anwendung nach einem der Ansprüche 1 bis 4, **dadurch gekennzeichnet, dass** die mehrschichtige Struktur eine Schicht aus Polymermaterial auf der Schicht (A) des Stapels auf der Seite umfasst, welche derjenigen, die die Schicht (B) berührt, gegenüberliegt.

6. Anwendung nach einem der Ansprüche 1 bis 5, **dadurch gekennzeichnet, dass** die mehrschichtige Struktur n Stapel umfasst, wobei n eine ganze positive Zahl größer 1 ist, wobei jeder Stapel eine SiO₂-Schicht (A) und eine SiOₓᵢN_{yi}H_{zi}-Schicht (B) umfasst, wobei i eine ganze positive Zahl zwischen 1 und n ist und zᵢ in jedem Fall kleiner als das Verhältnis (xᵢ+yᵢ)/5 ist, wobei zᵢ vorteilhafterweise in jedem Fall kleiner ist als das Verhältnis (xᵢ+yᵢ)/10, wobei xᵢ, yᵢ und zᵢ für die verschiedenen Werte von i identisch sind oder nicht.

7. Anwendung nach Anspruch 6, **dadurch gekennzeichnet, dass** die mehrschichtige Struktur wenigstens eine Schicht aus Polymermaterial umfasst, die zwischen der Schicht (A) eines Stapels und der Schicht (B) des direkt nachfolgenden Stapels angeordnet ist.

8. Anwendung nach Anspruch 7, **dadurch gekennzeichnet, dass** sie n-1 Schichten aus Polymermaterial umfasst, wobei jede der Schichten aus Polymermaterial zwischen zwei Stapeln angeordnet ist.

9. Anwendung nach einem der Ansprüche 1 bis 8,
**dadurch gekennzeichnet, dass** die mehrschichtige Struktur einen oder mehrere Stapel aufweist, die symmetrisch auf der einen und der anderen Seite des Substrats angeordnet sind.

10. Anwendung nach einem der Ansprüche 1 bis 9, **dadurch gekennzeichnet, dass** das halogenierte Polymer aus chlorierten und /oder fluorierten Homo- oder Copolymeren, vorzugsweise aus fluorierten Homo- und Copolymeren gewählt ist.

11. Anwendung nach Anspruch 10, **dadurch gekennzeichnet, dass** das fluorierte Polymer aus fluorierten Homo- und Copolymeren gewählt ist, die wenigstens 50% Mol aufweisen und vorteilhafterweise aus Monomeren mit folgender Formel (I) bestehen:
CFX=CHX' (I)
wobei X und X' unabhängig voneinander ein Wasserstoff- oder Halogenatom bezeichnen (insbesondere Fluor oder Chlor) oder einen Perhalogenalkylrest (insbesondere Perfluoralkyl), wie zum Beispiel:
- Polyvinylidenfluorid (PVDF), vorzugsweise als α-Form,
- Copolymere von Vinylidenfluorid, beispielsweise mit Hexafluorpropylen (HFP), Chlortrifluorethylen (CTFE), Hexafluorpropylen (HFP), Trifluorethylen (VF3) oder Tetrafluorethylen (TFE),
- Homo- und Copolymere von Trifluorethylen (VF3),
- Copolymere von Fluorethylen/-propylen (FEP),
- Ethylen-Copolymere mit Fluorethylen/-propylen (FEP), Tetrafluorethylen (TFE), Perfluormethylvinylether (PMVE), Chlortrifluorethylen (CTFE) oder Hexafluorpropylen (HFP), und
- ihre Mischungen.

12. Anwendung nach Anspruch 11, **dadurch gekennzeichnet, dass** das fluorierte Homo- oder Copolymer Polyvinylidenfluorid ist.

13. Anwendung nach einem der Ansprüche 1 bis 12, **dadurch gekennzeichnet, dass** die mehrschichtige Struktur die vordere Schutzfolie des PhotovoltaikModuls bildet.

14. Photovoltaik-Modul, welches durch eine Umhüllung geschützte Photovoltaik-Zellen sowie eine vordere Schutzfolie und eine hintere Schutzfolie umschließt, wobei die vordere und/oder die hintere Schutzfolie eine mehrschichtige Struktur gemäß der Definition in einem der Ansprüche 1 bis 13 aufweist und keine Glasschicht mit einer Dicke von 50 µm oder mehr umfasst.

## Claims

1. The use of a multilayer structure in the protective frontsheet and/or backsheet of a photovoltaic module comprising photovoltaic cells covered with an encapsulant, **characterized in that** said multilayer structure comprises:
(a) a substrate including at least one halogenated polymer, and
(b) at least one stack of an SiO₂ layer (A) and of a layer (B) made of SiOₓN_{y}H_{z} positioned between the substrate and the layer (A), in which the layer (A) and the layer (B) exhibit thicknesses (t_{A}, t_{B}) such that the thickness (t_{A}) of the layer (A) is less than or equal to 60 nm, the thickness (t_{B}) of the layer (B) is greater than twice the thickness (t_{A}) of the layer (A) and the sum of the thicknesses of the layer (A) and of the layer (B) is between 100 nm and 500 nm, and in which y and z are strictly greater than 0 and z is strictly less than the ratio (x+y)/5, advantageously z is strictly less than the ratio (x+y)/10,
said stack being positioned on the face of the substrate turned toward the encapsulant and optionally on the opposite face of the substrate,
and **in that** the protective frontsheet and/or backsheet in which the multilayer structure is included does not comprise a glass layer with a thickness of 50 µm or more and x varies from 2 to 0 and/or y varies from a value strictly greater than 0 and less than 1 up to a value of 1.

2. The use as claimed in claim 1, **characterized in that** the value of x decreases from the interface between the layer (B) and the layer (A) toward the substrate and the value of y increases from the interface between the layer (B) and the layer (A) toward the substrate.

3. The use as claimed in any one of claims 1 to 2, **characterized in that** the material of the layer (A) exhibits a Young's modulus (M_{A}) of greater than or equal to 30 GPa and the material of the layer (B) has a Young's modulus (M_{B}) of less than or equal to 20 GPa.

4. The use as claimed in any one of claims 1 to 3, **characterized in that** said at least one stack is obtained by conversion of a perhydropolysilazane, preferably by means of irradiation using UV radiation at a wavelength of greater than or equal to 200 nm and, simultaneously or successively, by means of irradiation using VUV radiation at a wavelength of less than or equal to 200 nm, under an atmosphere exhibiting an oxygen content of less than 500 ppm and a water content of less than or equal to 1000 ppm.

5. The use as claimed in any one of claims 1 to 4, **characterized in that** the multilayer structure comprises a layer made of polymer material on the layer (A) of said stack, on the face opposite that in contact with the layer (B).

6. The use as claimed in any one of claims 1 to 5, **characterized in that** the multilayer structure comprises n stacks, n being a positive integer greater than 1, each stack comprising an SiO₂ layer (A) and a layer (B) made of SiOₓᵢN_{yi}H_{zi}, i being a positive integer of between 1 and n and zᵢ being strictly less than the ratio (xᵢ+yᵢ)/5, advantageously zᵢ is strictly less than the ratio (xᵢ+yᵢ)/10, xᵢ, yᵢ and zᵢ being identical or different for the various values of i.

7. The use as claimed in claim 6, **characterized in that** the multilayer structure comprises at least one layer made of polymer material positioned between the layer (A) of a stack and the layer (B) of the stack directly following.

8. The use as claimed in claim 7, **characterized in that** it comprises n-1 layers made of polymer material, each of the layers made of polymer material being positioned between two stacks.

9. The use as claimed in any one of claims 1 to 8, **characterized in that** the multilayer structure comprises one or more stacks positioned symmetrically on both sides of the substrate.

10. The use as claimed in any one of claims 1 to 9, **characterized in that** the halogenated polymer is chosen from chlorinated and/or fluorinated homo- and copolymers, preferably fluorinated homo- and copolymers.

11. The use as claimed in claim 10, **characterized in that** the fluorinated polymer is chosen from fluorinated homo- and copolymers comprising at least 50 mol% and advantageously composed of monomers of formula (I):
CFX=CHX' (I)
where X and X' independently denote a hydrogen or halogen (in particular fluorine or chlorine) atom or a perhalogenated (in particular perfluorinated) alkyl radical, such as:
- poly(vinylidene fluoride) (PVDF), preferably in the α form,
- copolymers of vinylidene fluoride with, for example, hexafluoropropylene (HFP), chlorotrifluoroethylene (CTFE), hexafluoropropylene (HFP), trifluoroethylene (VF3) or tetrafluoroethylene (TFE),
- trifluoroethylene (VF3) homo- and copolymers,
- fluoroethylene/propylene (FEP) copolymers,
- copolymers of ethylene with fluoroethylene/propylene (FEP), tetrafluoroethylene (TFE), perfluoromethyl vinyl ether (PMVE), chlorotrifluoroethylene (CTFE) or hexafluoropropylene (HFP), and
- their blends.

12. The use as claimed in claim 11, **characterized in that** the fluorinated homo- or copolymer is poly(vinylidene fluoride).

13. The use as claimed in any one of claims 1 to 12, **characterized in that** the multilayer structure constitutes the protective frontsheet of the photovoltaic module.

14. A photovoltaic module including photovoltaic cells protected by an encapsulant, a protective frontsheet and a protective backsheet, in which the protective frontsheet and/or backsheet comprises a multilayer structure as defined in any one of claims 1 to 13 and does not comprise a glass layer with a thickness of 50 µm or more.
